# EUROPEAN PATENT APPLICATION

(11) **EP 4 770 371 A1**
(43) Date of publication of application: **01.07.2026**
(21) Application number: 25211373.3
(22) Date of filing: 27.10.2025
(51) Int. Cl.: H10K 59/124, H10K 59/131, H10K 59/80, H10K 59/40

(54) **LIGHT EMITTING DISPLAY APPARATUS**

(30) Priority: 31.12.2024 KR 20240202143
(71) Applicant: LG Display Co., Ltd., Seoul, 07336 (KR)
(72) Inventor: AHN, Jungjin, Gyeonggi-do (KR); RYU, Youngwan, Gyeonggi-do (KR)
(74) Representative: Morrall, Jonathan Ian McLachlan

(57) **Abstract**

A light emitting display apparatus according to an embodiment of the present disclosure may comprise a substrate comprising a display area and a pad area, a pixel circuit layer including a pixel circuit configured in the display area, an overcoat layer configured in the display area to cover the pixel circuit layer, a light emitting device layer configured on the overcoat layer and electrically connected to the pixel circuit, an encapsulation part configured on the overcoat layer to cover the light emitting device layer, and a pad part configured in the pad area and electrically connected to the pixel circuit. The overcoat layer may include an extension portion extending to a routing area between the display area and the pad area, and at least a portion of the extension portion of the overcoat layer may have a same thickness as a central portion of the overcoat layer.

## Description

### CROSS-REFERENCE TO RELATED APPLICATION

This application claims the benefit of and priority to Korean Patent Application No. 10-2024-0202143 filed on December 31, 2024, the entirety of which is hereby incorporated by reference for all purposes as if fully set forth herein.

### Technical Field

The present disclosure relates to a light emitting display apparatus.

### Background Art

A light emitting display apparatus is a self-luminous display device that do not require a separate light source, unlike liquid crystal display apparatus, so the light emitting display apparatus may be manufactured in a lightweight and thin manner. In addition, the light emitting display apparatus is in the spotlight as next-generation display apparatus because they are advantageous in terms of power consumption by driving low voltage and have excellent color arrangement, response speed, viewing angle, and contrast ratio.

The light emitting display apparatus displays an image through light emission of a light emitting device layer including a light emitting device interposed between two electrodes. In this case, light generated according to light emission of the light emitting device is emitted to the outside through a substrate or the like.

### SUMMARY

In the light emitting display apparatus, an encapsulation part for protecting a light emitting device layer from hydrogen and moisture is disposed on the light emitting device layer. The encapsulation part includes an inorganic layer and an organic layer. The inorganic layer is formed by deposition of an inorganic material using a metal mask process. For example, in the process of forming the inorganic layer, sagging (or deflection) of the mask occurs, and since a weight (or load) of the mask is concentrated in a sagging region of the mask, defects such as cracks, pressing, or dents (or indentations) and the like may occur in lower layers of the encapsulation part. Due to such defects, a step coverage of an upper layer formed after the mask is removed may become weak (or deficient) step coverage. Through such weak portions, hydrogen and moisture may penetrate, and deterioration and reliability problems of a device (or the light emitting device layer) may occur.

In order to solve the above-described problems, the inventors of the present disclosure have conducted continuous various experiments, and through the various experiments, invented a light emitting display apparatus having a new structure capable of preventing defects such as cracks and/or dents (or indentations) and the like occurring in a mask contact region that is in contact with a sagging portion of the mask.

One or more aspects of the present disclosure are directed to providing a light emitting display apparatus capable of preventing defects such as cracks and/or dents (or indentations) and the like occurring in a mask contact region that is in contact with a sagging portion of the mask.

One or more aspects of the present disclosure are directed to providing a light emitting display apparatus with improved reliability.

Additional features, advantages, and aspects of the present disclosure are set forth in part in the present disclosure and will also be apparent from the present disclosure or may be learned by practice of the inventive concepts provided herein. Other features, advantages, and aspects of the present disclosure may be realized and attained by the descriptions provided in the present disclosure, or derivable therefrom, and claims hereof as well as the appended drawings.

To achieve these and other advantages and aspects of the present disclosure, as embodied and broadly described herein, in one or more aspects, a light emitting display apparatus may comprise a substrate comprising a display area and a pad area, a pixel circuit layer including a pixel circuit configured in the display area, an overcoat layer configured in the display area to cover the pixel circuit layer, a light emitting device layer configured on the overcoat layer and electrically connected to the pixel circuit, an encapsulation part configured on the overcoat layer to cover the light emitting device layer, and a pad part configured in the pad area and electrically connected to the pixel circuit. The overcoat layer may include an extension portion extending to a routing area between the display area and the pad area, and at least a portion of the extension portion of the overcoat layer may have a same thickness as a central portion of the overcoat layer.

Details of other exemplary embodiments will be included in the detailed description of the disclosure and the accompanying drawings.

According to one or more embodiments of the present disclosure, the light emitting display apparatus may support a mask for forming an encapsulation part without an additional process and may prevent defects such as cracks, pressing, and/or dents (or indentations) and the like occurring in a contact region between the mask and the extension portion, by including an extension portion in which an overcoat layer extends to a routing area and configuring such that at least a portion of the extension portion has a same thickness as a central portion of the overcoat layer.

According to one or more embodiments of the present disclosure, the light emitting display apparatus may uniformly maintain a weight (or load) applied to the extension portion in a contact region between the mask and the extension portion, by configuring a thickness of the extension portion uniformly in a routing area. Accordingly, defects such as cracks, pressing, and/or dents (or indentations) and the like occurring in the routing area may be prevented.

According to one or more embodiments of the present disclosure, since defects occurring in the contact region between the mask and the extension portion may be prevented, weakening (or deficiency) of the step coverage of an upper layer subsequently formed after the mask removal may be prevented, thereby avoiding weak (or deficient) step coverage. Accordingly, since a moisture permeable path of the light emitting display apparatus is blocked, penetration of hydrogen and moisture may be prevented, and deterioration of the light emitting display apparatus may be prevented.

According to one or more embodiments of the present disclosure, the light emitting display apparatus with improved reliability may be provided, a long lifespan may be realized, and low-power driving may be possible.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with aspects of the disclosure.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure and together with the description serve to explain principles of the disclosure. However, the technical features of the present embodiment are not limited to those shown in the specific drawings, and the features disclosed in each drawing may be combined to form a new embodiment.
FIG. 1 is a plan view illustrating a light emitting display apparatus according to an embodiment of the present disclosure.
FIG. 2 is a cross-sectional view illustrating a light emitting display apparatus according to an embodiment of the present disclosure.
FIG. 3 is an enlarged view schematically illustrating portion 'A' illustrated in FIG. 2.
FIG. 4 is an enlarged view schematically illustrating portion 'B' illustrated in FIG. 1.
FIG. 5 is a cross-sectional view taken along line I-I' of FIG. 4.
FIG. 6 is a cross-sectional view taken along line II-II' of FIG. 4 according to an embodiment.
FIG. 7 is a cross-sectional view taken along line II-II' of FIG. 4 according to another embodiment.
FIGs. 8A to 8D are diagrams illustrating defects in a routing area of a light emitting display apparatus according to an experimental example.
FIGs. 9A and 9B are diagrams illustrating a routing area of a light emitting display apparatus according to an embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and convenience.

### DETAILED DESCRIPTION OF THE DISCLOSURE

Advantages and features of the present disclosure, and implementation methods thereof, are clarified through the aspects described with reference to the accompanying drawings. The present disclosure may, however, be embodied in different forms and should not be construed as limited to the example aspects set forth herein. Rather, these example aspects are examples and are provided so that this disclosure may be thorough and complete to assist those skilled in the art to understand the inventive concepts without limiting the protected scope of the present disclosure.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In addition, in a situation where "comprise," "have," and "include" described in the present disclosure are used, another part may be added unless "only" is used. The terms of a singular form can include plural forms unless referred to the contrary.

In construing an element, the element is construed as including an error range although there is no explicit description.

In describing a position relationship, for example, when a position relation between two parts is described as "on", "over", "under", "next", and "adjacent to" or the like, one or more other parts may be located between the two parts unless a more limiting term, such as "immediate(ly)", "direct(ly)", or "close(ly)" is used.

In describing a time relationship, for example, when the temporal order is described as, for example, "after", "subsequent", "next", and "before", or the like, a case that is not continuous may be included unless a more limiting term, such as "just", "immediate(ly)", or "direct(ly)" is used.

It will be understood that, although the terms "first", "second", etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing elements of the present disclosure, the terms "first", "second", "A", "B", "(a)", "(b)", etc. may be used. These terms are intended to identify the corresponding elements from the other elements, and basis, order, or number of the corresponding elements should not be limited by these terms. The expression that an element or layer is "connected", "coupled", or "adhered" to another element or layer means the element or layer may not only be directly connected or adhered to another element or layer, but also be indirectly connected or adhered to another element or layer with one or more intervening elements or layers "disposed" or "interposed" between the elements or layers, unless otherwise specified.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various aspects of the present disclosure may be partially or overall coupled to or combined with each other, and may be variously inter-operated with each other and driven technically as those skilled in the art may sufficiently understand. Aspects of the present disclosure may be carried out independently from each other, or may be carried out together in co-dependent relationship.

Hereinafter, example embodiments of a light emitting display apparatus according to the present disclosure will be described in detail with reference to the accompanying drawings. For convenience of description, a scale of each of elements illustrated in the accompanying drawings differs from a real scale, and thus, is not limited to a scale illustrated in the drawings.

The light emitting display apparatus according to an embodiment of the present disclosure may be a flexible light emitting display apparatus, a light emitting display panel, or a flexible light emitting display panel, but embodiments of the present disclosure are not limited thereto. For example, the light emitting display apparatus according to an embodiment of the present disclosure may include a set electronic apparatus or a set device (or a set apparatus) such as a notebook computer, a television, a computer monitor, an equipment apparatus including a light emitting display apparatus for vehicles (or an automotive) or another type apparatus for vehicles, or a mobile electronic apparatus such as a smartphone or an electronic pad and or the like, which is a complete product (or a final product) including a light emitting display panel.

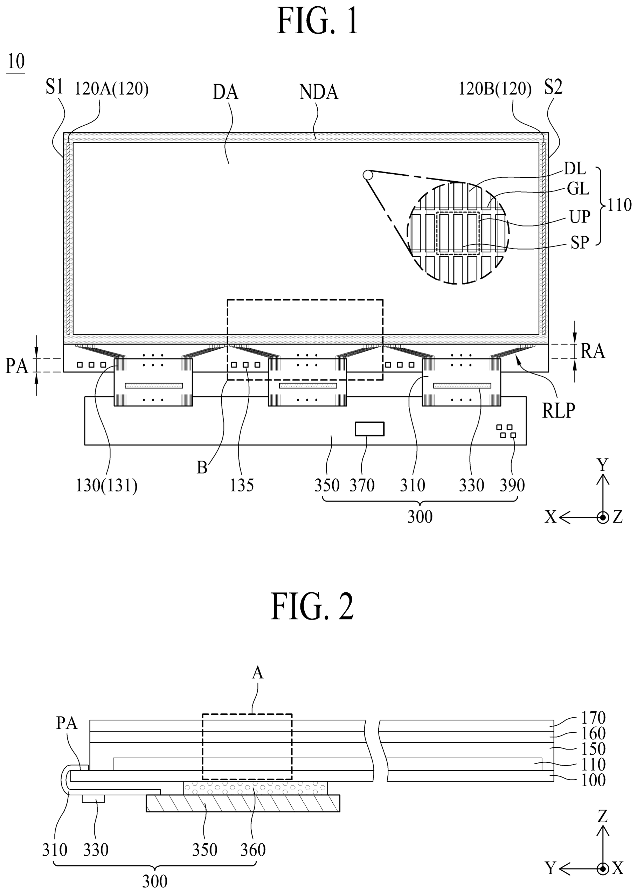

FIG. 1 is a plan view illustrating a light emitting display apparatus according to an embodiment of the present disclosure. FIG. 2 is a cross-sectional view illustrating a light emitting display apparatus according to an embodiment of the present disclosure.

Referring to FIGs. 1 and 2, a light emitting display apparatus (or light emitting display panel) 10 according to an embodiment of the present disclosure may include a substrate 100 having a display area DA, a non-display area NDA, a routing area RA, and a pad area PA.

The display area DA may be an area which displays an image, and may be a pixel array area, an active area, a pixel array part, a display part, or a screen. For example, the display area DA may be disposed at a central portion of the light emitting display apparatus (or the light emitting display panel).

The non-display area NDA may be an area which does not display an image. The non-display area NDA may be a peripheral region of the display area DA. For example, the non-display area NDA may be implemented to surround the display area DA. For example, the non-display area NDA may include an edge portion of the substrate 100. For example, the non-display area NDA may be a non-display part, an inactive area, an inactive part, a peripheral part, or a peripheral area.

The routing area RA may be an extension region extending from one side of the non-display area NDA. The routing area RA may be an area extending from at least a portion of a long-side of one side of the non-display area NDA to have a predetermined length along a second direction Y. The routing area RA may include a plurality of data link lines. Each of the plurality of data link lines may electrically connect a plurality of display data pads to a plurality of data lines in a one-to-one correspondence. For example, the routing area RA may be an extension portion, an enlarged portion, a routing portion, a signal transmission portion, an enlarged area, or a signal transmission area.

The pad area PA may extend from the routing area RA along the second direction Y. The pad area PA may correspond to a circuit connection portion, a circuit connection area, a circuit connection section, or a signal input/output area. The pad area PA may include a plurality of display data pads, at least one pixel driving power pad, and a plurality of common power pads.

The light emitting display apparatus (or the light emitting display panel) 10 according to an embodiment of the present disclosure may further include a pixel part 110, a gate driving circuit 120, and a plurality of pad parts 130.

The pixel part 110 may be implemented at the display area DA of the substrate 100 and may display a black and white image or a color image. For example, the pixel part 110 may be a pixel layer, a pixel array, a pixel array layer, or a pixel array part.

The pixel part 110 may include a plurality of pixels UP disposed at the display area DA. Each of the plurality of pixels UP may be configured in each pixel areas provided by pixel drive lines. For example, each of the plurality of pixels UP may be implemented at each pixel areas provided by a plurality of gate lines GL and a plurality of data lines DL.

The pixel part 110 may be configured to include a light emitting device having an emission structure. For example, the emission structure may include a light emitting layer (or an organic light emitting layer), but embodiments of the present disclosure are not limited thereto, and the emission structure may include an inorganic light emitting layer (or an inorganic light emitting diode).

Each of the plurality of pixels UP may be configured to implement a black and white image or a color image. One pixel UP may be a unit pixel. Each of the plurality of pixels UP may include a plurality of sub-pixels SP. For example, each of the plurality of sub-pixels SP may be implemented in each sub-pixel areas provided by the pixel drive lines. For example, each of the plurality of sub-pixels SP may be implemented at each sub-pixel areas provided by the plurality of gate lines GL and the plurality of data lines DL. For example, each of the plurality of sub-pixels SP may be configured to implement any one of a plurality of colors (or light) implementing a color image (or color light). For example, each of the plurality of sub-pixels SP may be configured to include a light emitting device implementing any one of red light, green light, blue light, and white light.

The gate driving circuit 120 may be implemented in the non-display area NDA adjacent to the display area DA to be electrically connected to the plurality of gate lines GL. The gate driving circuit 120 may be implemented in a short-side area of the non-display area NDA to be electrically connected to the plurality of gate lines GL. For example, the gate driving circuit 120 may be implemented in one or more of a pair of short-side areas of the non-display area NDA to be electrically connected to the plurality of gate lines GL.

The gate driving circuit 120 according to an embodiment of the present disclosure may be directly formed or implemented on the substrate 100 by a manufacturing process of a thin film transistors of the pixels based on a GIP (gate in panel) scheme. For example, the gate driving circuit 120 may be a gate built-in circuit (or an embedded gate circuit) or a gate shift register circuit, but embodiments of the present disclosure are not limited thereto.

The gate driving circuit 120 according to an embodiment of the present disclosure may include one or more of a first gate driving circuit 120A and a second gate driving circuit 120B.

The first gate driving circuit 120A may be implemented in a first short-side area of a non-display area NDA adjacent to a first side (or one side) of the display area DA.

The second gate driving circuit 120B may be implemented in a second short-side area of the non-display area NDA adjacent to a second side (or the other side), which is opposite to the first side, of the display area DA.

According to an embodiment of the present disclosure, the first gate driving circuit 120A may be electrically connected to one end of each of the plurality of gate lines GL disposed in the pixel part 110, and the second gate driving circuit 120B may be electrically connected to the other end of each of the plurality of gate lines GL disposed in the pixel part 110.

According to another embodiment of the present disclosure, the first gate driving circuit 120A may be electrically connected to the one end of each odd-numbered (or even-numbered) gate line among the plurality of gate lines GL disposed in the pixel part 110, and the second gate driving circuit 120B may be electrically connected to the other end of each even-numbered (or odd-numbered) gate line among the plurality of gate lines GL disposed in the pixel part 110.

The plurality of pad parts 130 may be implemented in the non-display area NDA of the substrate 100. The plurality of pad parts 130 may be electrically connected to the pixel circuits and may be electrically connected to the gate driving circuit 120. For example, the plurality of pad parts 130 may be electrically connected to the pixel driving lines for driving the pixel circuits and may be electrically connected to the gate driving circuit 120.

Each of the plurality of pad parts 130 may be disposed to have a predetermined interval along the first direction X. Each of the plurality of pad parts 130 may include a plurality of pads 131. For example, each of the plurality of pad parts 130 may include a plurality of display data pads, a plurality of pixel driving voltage pads, a plurality of cathode voltage pads, and a plurality of touch data pads. For example, a first pad part connected to the first data line among the plurality of pad parts 130 may further include a plurality of gate pads. In addition, a last pad part connected to the last data line among the plurality of pad parts 130 may further include a plurality of gate pads.

Each of the plurality of gate pads may be electrically connected to the gate driving circuit 120 through a plurality of gate control signal lines disposed in the routing area RA. For example, the plurality of gate pads disposed in the first pad part may be electrically connected to the first gate driving circuit 120A through the plurality of gate control signal lines disposed in the routing area RA, and the plurality of gate pads disposed in the last pad part may be electrically connected to the second gate driving circuit 120B through the plurality of gate control signal lines disposed in the routing area RA.

The light emitting display apparatus (or the light emitting display panel) according to an embodiment of the present disclosure may further include a panel driving circuit part 300.

The panel driving circuit part 300 (or an external panel circuit) may be connected to the pad parts 130 of the light emitting display panel 10. The panel driving circuit part 300 may drive (or emits light) the plurality of pixels UP disposed in the display area DA based on image data supplied from a host driving system, thereby displaying an image corresponding to the image data on the display area DA.

The panel driving circuit part 300 according to an embodiment may include a plurality of flexible circuit films 310, a plurality of data driving integrated circuits 330, a printed circuit board 350, a timing control part 370, and a power circuit part 390.

One side edge portion (or an input bonding portion) of each of the plurality of flexible circuit films 310 may be attached to or electrically connected to the printed circuit board 350 through a film attachment process using an anisotropic conductive film. The other side edge portion (or an output bonding portion) of each of the plurality of flexible circuit films 310 may be attached to or electrically connected to the plurality of pad parts 130 of the substrate 100 through a film attachment process using an anisotropic conductive film. Each of the plurality of flexible circuit films 310 may be bent or folded toward a rear surface of the substrate 100 to surround a side surface (or a lateral surface) of the substrate 100. For example, the one side edge portion of each of the plurality of flexible circuit films 310 may be disposed on the rear surface of the substrate 100.

Each of the plurality of data driving integrated circuits 330 may be individually mounted on each of the plurality of flexible circuit films 310. Each of these data driving integrated circuits 330 may receive pixel data and data control signals provided from the timing control part 370, and convert the pixel data into analog pixel data signals for each pixel based on the data control signal to supply to corresponding data lines. For example, the flexible circuit films 310 and the data driving integrated circuits 330 may be referred to as data driving circuits or the like, but are not limited thereto.

The printed circuit board 350 may support the timing control part 370 and the power circuit part 390 and may transfer signals and powers between the components of the panel driving circuit part 300. For example, the printed circuit board 350 may be attached to the rear surface of the substrate 100 using an adhesive member 360.

The timing control part 370 may be mounted on the printed circuit board 350 and may receive image data and timing synchronization signals which are provided from a host driving system through a user connector disposed on the printed circuit board 350. The timing control part 370 may generate the pixel data by aligning the image data so as to match a pixel arrangement structure in the display area DA based on the timing synchronization signals and provide the generated pixel data to the corresponding data driving integrated circuits 330. In addition, the timing control part 370 may generate data control signals and gate control signals based on the timing synchronization signals, control the driving timing of each of the plurality of data driving integrated circuits 330 through the data control signals, and control the driving timing of the first and second gate driving circuits 120A and 120B through the gate control signals.

The power circuit part 390 may be mounted on the printed circuit board 350 and may generate various voltages necessary for displaying an image on the light emitting display device (or the light emitting display panel) 10 using an input power supplied from the outside and provide the generated voltages to the corresponding circuits.

The light emitting display apparatus (or the light emitting display panel) 10 according to an embodiment of the present disclosure may further include a test circuit part 135 disposed at the pad area PA.

The test circuit part 135 may include a plurality of test thin film transistors electrically connected to the plurality of data lines disposed in the pixel part 110, one or more enable signal pads, and one or more test signal pads. In a test process performed before the panel driving circuit part 300 is mounted on the substrate 100, each of the plurality of test thin film transistors may be turned on by an enable signal applied through a enable signal pad and may supply a test signal, applied through a test signal pad, to each of the plurality of data lines.

The light emitting display apparatus (or the light emitting display panel) 10 according to an embodiment of the present disclosure may further include an encapsulation part 150 which covers or surrounds the pixel part 110. The encapsulation part 150 may be configured to protect the pixel part 110. For example, the encapsulation part 150 may be configured to prevent external oxygen or water from penetrating into the emission structure of the pixel part 110.

The light emitting display apparatus (or the light emitting display panel) 10 according to an embodiment of the present disclosure may further include a touch sensing part 160.

The touch sensing part 160 may be disposed or provided on the encapsulation part 150. For example, the touch sensing part 160 may be directly formed or provided at the encapsulation part 150. The touch sensing part 160 may include a touch sensor which senses a user touch. The touch sensing part 160 according to an embodiment of the present disclosure may include a plurality of touch driving electrodes and a plurality of touch sensing electrodes for sensing a touch on the basis of a mutual capacitance scheme. The touch sensing part 160 according to another embodiment of the present disclosure may include a plurality of touch electrodes (or touch sensing electrodes) for sensing a touch on the basis of a self-capacitance scheme.

The light emitting display apparatus (or the light emitting display panel) 10 according to an embodiment of the present disclosure may include a counter substrate 170. The counter substrate 170 according to an embodiment of the present disclosure may be disposed on the touch sensing part 160.

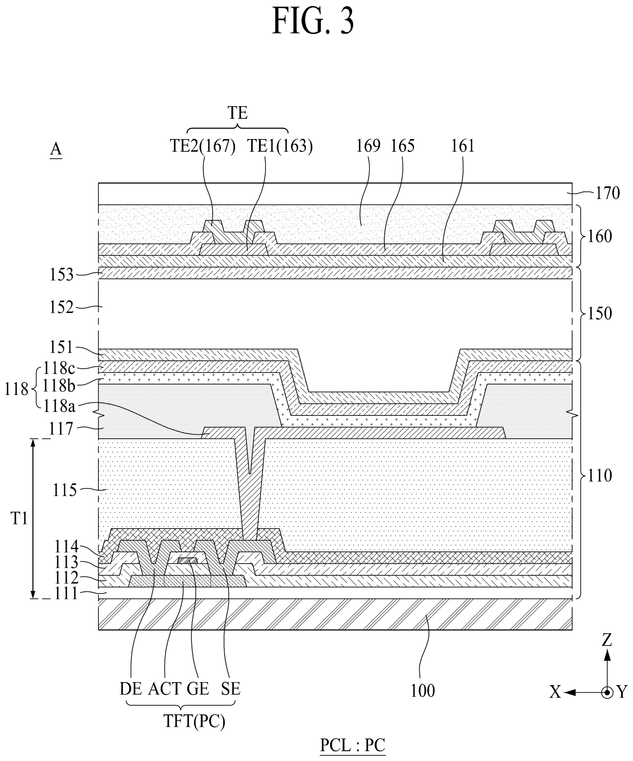

FIG. 3 is an enlarged view schematically illustrating portion 'A' illustrated in FIG. 2. FIG. 3 is a cross-sectional view schematically illustrating one sub-pixel illustrated in FIGs. 1 and 2.

Referring to FIGs. 1 to 3, the light emitting display apparatus (or the light emitting display panel) 10 according to an embodiment of the present disclosure may include a substrate 100, a pixel part 110, an encapsulation part 150, and a touch sensing part 160.

The substrate 100 includes thin film transistors, and may be a transistor array substrate, a lower substrate, a base substrate, or a first substrate. For example, the substrate 100 may be a transparent glass substrate or a transparent plastic substrate.

The pixel part 110 may include a buffer layer 111, a pixel circuit layer PCL, an overcoat layer 115, and a light emitting device layer 118.

The buffer layer 111 may be disposed on the substrate 100. The buffer layer 111 may prevent a material of the substrate 100 from being diffused to a transistor in performing a high temperature process in a manufacturing process of the thin film transistor, or may prevent external water or moisture from penetrating into the light emitting device layer 118. Optionally, the buffer layer 111 may be omitted based on the kind and material of the substrate 100.

The pixel circuit layer PCL may be disposed on the substrate 100. The pixel circuit layer PCL may include a pixel circuit PC configured in the display area DA on the substrate 100. The pixel circuit PC may include a driving thin film transistor TFT which is disposed in the pixel area on the substrate 100 or on the buffer layer 111.

The driving thin film transistor TFT may include an active layer ACT, a gate electrode GE, a source electrode SE, and a drain electrode DE.

The active layer ACT may be disposed on the substrate 100 or the buffer layer 111. For example, the active layer ACT may include a semiconductor material based on metal oxide such as indium-gallium-zinc-oxide (IGZO), but is not limited thereto, and may include a semiconductor material based on silicon such as amorphous silicon or polycrystalline silicon. For example, the active layer ACT may be formed in a patterned shape by depositing a semiconductor material on the buffer layer 111, performing a heat treatment process (or an annealing process) for stabilization, and performing a patterning process of the semiconductor material.

The active layer ACT may include a source region, a drain region, and a channel region between the source region and the drain region. The active layer ACT may be covered by a first insulating layer (or a gate insulating layer) 112.

The first insulating layer 112 may be formed in an island shape on only the channel region of the active layer ACT, or may be formed to cover an entire front surface of the buffer layer 111 or the substrate 100 including the active layer ACT. The first insulating layer 112 may be configured as an inorganic material, but is not limited thereto, and may be configured as an organic material.

The gate electrode GE may be disposed on the first insulating layer 112 to overlap the channel region of the active layer ACT. The gate electrode GE may be formed of a gate metal material. For example, the gate electrode GE may be formed together with the gate line.

The gate electrode GE may be covered by a second insulating layer (or an interlayer insulating layer) 113. The second insulating layer 113 may be formed on the first insulating layer 112 to cover the gate electrode GE. The second insulating layer 113 may be configured as an inorganic material, but is not limited thereto, and may be configured as an organic material.

The source electrode SE may be disposed on the second insulating layer 113 to be electrically connected to the source region of the active layer ACT. The source electrode SE may be electrically connected to the source region of the active layer ACT through a contact hole formed in the first insulating layer 112 and the second insulating layer 113 overlapping the source region of the active layer ACT.

The drain electrode DE may be disposed on the second insulating layer 113 to be electrically connected to the drain region of the active layer ACT. The drain electrode DE may be electrically connected to the drain region of the active layer ACT through a contact hole formed in the first insulating layer 112 and the second insulating layer 113 overlapping the drain region of the active layer ACT.

The source electrode SE and the drain electrode DE may be formed of a source/drain metal material. For example, the source electrode SE and the drain electrode DE may be configured as a same or different conductive materials as the gate electrode GE. The source electrode SE and the drain electrode DE may be formed together with the data line DL described above with reference to FIG. 1.

The pixel circuit PC may further include at least one switching thin film transistor and at least one capacitor, which are disposed at the pixel area. The at least one switching thin film transistor and the at least one capacitor may be formed together with the driving thin film transistor TFT.

A passivation layer 114 may be disposed over the pixel circuit layer PCL. The pixel circuit PC may be covered by the passivation layer 114. The passivation layer 114 may be configured as an inorganic material, but is not limited thereto, and may also be configured as an organic material. The passivation layer 114 may be omitted.

The overcoat layer 115 may be disposed at the display area DA. The overcoat layer 115 may cover the pixel circuit layer PCL. The overcoat layer 115 may cover the pixel circuit PC or the passivation layer 114. For example, the overcoat layer 115 may planarize a top surface of the pixel circuit PC or the passivation layer 114 and may be configured to protect the pixel circuit PC. The overcoat layer 115 may be configured as an organic material. For example, the overcoat layer 115 may be formed of an organic material including acrylic resin, epoxy resin, phenolic resin, polyamide resin, or polyimide resin.

The light emitting device layer 118 may be disposed on the overcoat layer 115. The light emitting device layer 118 may be electrically connected to the driving thin film transistor TFT or the pixel circuit PC on the overcoat layer 115.

The light emitting device layer 118 may include a first electrode 118a, a light emitting device 118b, and a second electrode 118c.

The first electrode 118a may be disposed in a patterned shape on the overcoat layer 115. The first electrode 118a may be electrically connected to a source electrode SE of the driving thin film transistor TFT through an electrode contact hole formed in the overcoat layer 115.

The first electrode 118a may be an anode electrode (or a cathode electrode). For example, when the light emitting display apparatus 10 according to an embodiment of the present disclosure has a top emission structure, the first electrode 118a may be a reflective electrode that reflects light. When the light emitting display apparatus 10 according to another embodiment of the present disclosure has a bottom emission structure, the first electrode 118a may be a transparent electrode that transmits light.

The light emitting device 118b may be disposed on the first electrode 118a. The light emitting device 118b may include one or more emission structures which is stacked on the first electrode 118a in the order or reverse order of a hole layer, a light emitting layer, and an electron layer. For example, the light emitting device 118b may be implemented to generate color light corresponding to a corresponding sub-pixel. For example, when the unit pixel includes red, green, and blue sub-pixels, the light emitting device 118b of the red sub-pixel may generate red light, the light emitting device 118b of the green sub-pixel may generate green light, and the light emitting device 118b of the blue sub-pixel may generate blue light.

The second electrode 118c may be disposed on the light emitting device 118b. The second electrode 118c may be disposed on the light emitting device 118b so as to face the first electrode 118a with the light emitting device 118b therebetween.

The second electrode 118c may be a cathode electrode (or an anode electrode). For example, when the light emitting display apparatus 10 according to an embodiment of the present disclosure has the top emission structure, the second electrode 118c may be a transparent electrode that transmits light. When the light emitting display apparatus 10 according to another embodiment of the present disclosure has the bottom emission structure, the second electrode 118c may be a reflective electrode that reflects light.

The light emitting display apparatus 10 according to an embodiment of the present disclosure may further include a bank 117.

The bank 117 may define an opening portion (or an emission region) of the sub-pixel SP and may be disposed to cover an edge portion of the first electrode 118a. For example, the bank 117 may be disposed on the overcoat layer 115 so as to cover only the edge portion except for a central portion of the first electrode 118a. For example, the bank 117 may be formed of an organic material or an inorganic material, and may include a light-absorbing material including a black pigment.

The light emitting device 118b may be disposed only in the opening portion of each sub-pixel SP provided by the bank 117, or may be disposed on the bank 117 and the opening portion of each sub-pixel SP.

The encapsulation part (or an encapsulation layer) 150 may be configured to cover or surround the pixel part 110. For example, the encapsulation part 150 may be disposed on the light emitting device layer 118 and may cover or surround the light emitting device layer 118.

The encapsulation part 150 may include one or more encapsulation parts. For example, the encapsulation part 150 may include one or more inorganic material layers and one or more organic material layers on the light emitting device layer 118. For example, the encapsulation part 150 may include a first encapsulation part 151, a second encapsulation part 152, and a third encapsulation part 153.

The first encapsulation part 151 may be disposed on the second electrode 118c. The second encapsulation part 152 may be disposed on the second electrode 118c or on the first encapsulation part 151. The third encapsulation part 153 may be disposed on the second electrode 118c or on the second encapsulation part 152. For example, the encapsulation part 150 may include the first encapsulation part 151 on the second electrode 118c, the second encapsulation part 152 on the first encapsulation part 151, and the third encapsulation part 153 on the second encapsulation part 152. For example, the first and third encapsulation parts 151 and 153 may be inorganic material layers, and the second encapsulation part 152 may be an organic material layer.

The light emitting display apparatus (or the light emitting display panel) 10 according to an embodiment of the present disclosure may further include a touch sensing part 160 which is disposed on the display area DA of the substrate 100.

The touch sensing part 160 may be disposed on the encapsulation part 150. For example, the touch sensing part 160 may be disposed on the third encapsulation part 153 of the encapsulation part 150.

The touch sensing part 160 may include a touch buffer layer 161, a first touch electrode layer 163, a touch insulating layer 165, a second touch electrode layer 167, and a touch protection layer 169.

The touch buffer layer 161 may be disposed on the third encapsulation part 153 of the encapsulation part 150. For example, the touch buffer layer 161 may be formed of an inorganic material, but is not limited thereto.

The first touch electrode layer 163 may include a plurality of first touch electrodes TE1 which are disposed on the touch buffer layer 161. The plurality of first touch electrodes TE1 may be made of a transparent metal or an opaque metal. For example, the plurality of first touch electrodes TE1 may be a plurality of bridge electrodes or a plurality of bridge lines, but are not limited thereto.

The touch insulating layer 165 may be disposed on the touch buffer layer 161 to cover the first touch electrode layer 163. The touch insulating layer 165 may be formed of an inorganic material, but is not limited thereto.

The second touch electrode layer 167 may include a plurality of second touch electrodes TE2 which are disposed on the touch insulating layer 165. The plurality of second touch electrodes TE2 may be made of a transparent metal or an opaque metal. For example, each of the plurality of second touch electrodes TE2 may include a mesh structure. For example, the plurality of second touch electrodes TE2 may be a plurality of touch sensing electrodes or a plurality of touch driving electrodes, but are not limited thereto.

In the second touch electrode layer 167, each of the plurality of second touch electrodes TE2 disposed adjacent to each other in a first direction X or a second direction Y may be connected to each of the plurality of first touch electrodes TE1 through via holes provided in the touch insulating layer 165. Accordingly, each of the plurality of second touch electrodes TE2 disposed adjacent to each other in the first direction X or the second direction Y may be connected to one another through the plurality of first touch electrodes TE1. For example, the plurality of second touch electrodes TE2 disposed adjacent to each other in the second direction Y may be connected to one another through the plurality of first touch electrodes TE1.

The touch protection layer 169 may be disposed on the touch insulating layer 165 to cover the second touch electrode layer 167. The touch protection layer 169 may be configured to planarize a top surface of the touch sensing part 160 and to protect the touch sensing part 160. The touch protection layer 169 may be formed of an organic material, but is not limited thereto.

The light emitting display apparatus (or the light emitting display panel) 10 according to an embodiment of the present disclosure may further include a counter substrate 170. The counter substrate 170 according to an embodiment of the present disclosure may be disposed on the touch sensing part 160.

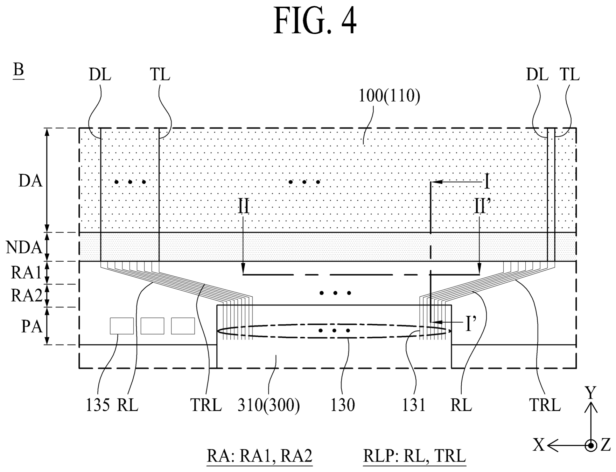

FIG. 4 is an enlarged view schematically illustrating portion 'B' illustrated in FIG. 1.

Referring to FIGs. 1 and 4, The light emitting display apparatus (or the light emitting display panel) 10 according to an embodiment of the present disclosure may include a plurality of routing line portions RLP disposed between each of the plurality of pad parts 130 and the display area DA.

The plurality of routing line portions RLP may be disposed (or configured) to electrically connect each of the pixel part 110 and the touch sensing part 160 to the pad part 130. Each of the plurality of routing line portions RLP may be disposed in the routing area RA between the display area DA and the pad area PA of the substrate 100.

Each of the plurality of routing line portions RLP may include a plurality of display routing lines RL and a plurality of touch routing lines TRL.

The plurality of display routing lines RL may be disposed in the routing area RA so as to be electrically connected to the plurality of data lines disposed in the display area DA of the substrate 100 and to be electrically connected to the plurality of display data pads 131 disposed in the pad part 130. A first end portion of each of the plurality of display routing lines RL may be electrically connected to an end portion of each of the plurality of data lines DL in one side area of the non-display area NDA. A second end portion of each of the plurality of display routing lines RL may be electrically connected to each of the plurality of display data pads 131 in the pad area PA. For example, each of the plurality of display routing lines RL may be a data routing line or a first routing line.

The plurality of touch routing lines TRL may be electrically connected to touch lines TL extending from the plurality of second touch electrodes TE2 which are disposed in the touch sensing part 160, respectively. A first end portion of each of the plurality of touch routing lines TRL may be electrically connected to an end portion of each of the plurality of touch lines TL in the one side area of the non-display area NDA. A second end portion of each of the plurality of touch routing lines TRL may be electrically connected to the plurality of touch data pads 131 in the pad area PA, respectively. For example, the plurality of display routing lines RL and the plurality of touch routing lines TRL may be disposed in different layers. For example, each of the plurality of touch routing lines TRL may be disposed between two or more adjacent display routing lines among the plurality of display routing lines RL, but is not limited thereto. For example, each of the plurality of touch routing lines TRL may be a second routing line.

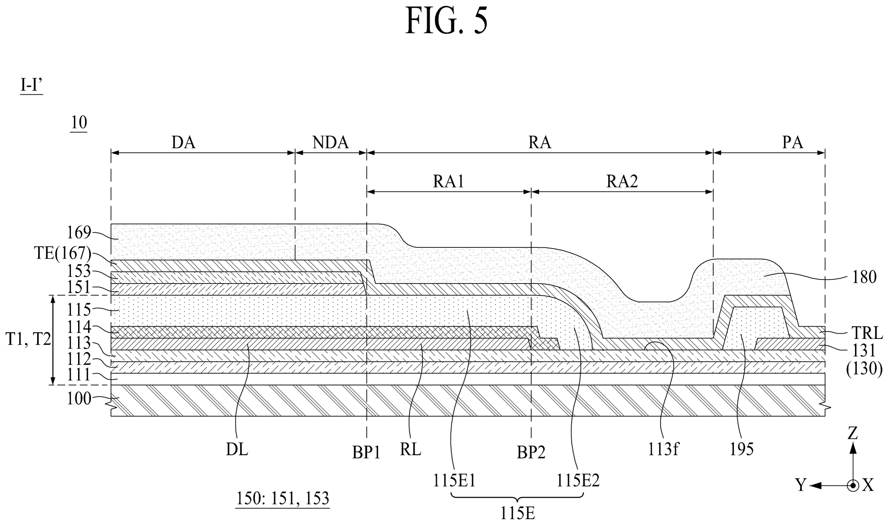

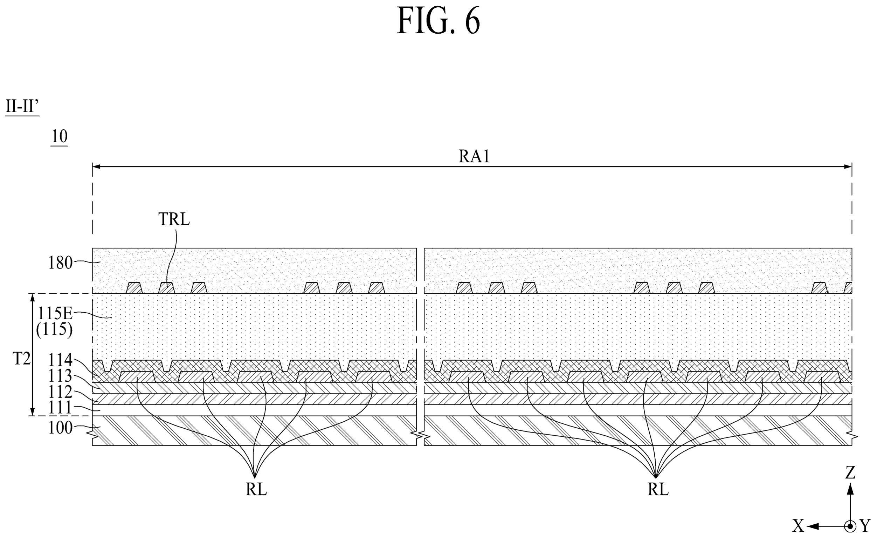

FIG. 5 is a cross-sectional view taken along line I-I' of FIG. 4. FIG. 6 is a cross-sectional view taken along line II-II' of FIG. 4 according to an embodiment. FIGs. 5 and 6 are a cross-sectional view according to an embodiment of the present disclosure described above with reference to FIGs. 1 to 4. Therefore, hereinafter, the same components (or elements) are briefly described or omitted

Referring to FIGs. 1 and 3 to 6, the light emitting display apparatus (or the light emitting display panel) 10 according to an embodiment of the present disclosure may include a buffer layer 111, a first insulating layer 112, a second insulating layer 113, data lines DL, display routing lines RL, pads 131, a passivation layer 114, an overcoat layer 115, a pad protection layer 195, an encapsulation part 150, touch routing lines TRL, a touch protection layer 169, and a cover layer 180.

The buffer layer 111, the first insulating layer 112, and the second insulating layer 113 may be sequentially stacked on an entire surface of the substrate 100. Since the buffer layer 111, the first insulating layer 112, and the second insulating layer 113 are a same as in FIG. 3, and thus, the detailed description will be omitted.

The data lines DL may be configured in a same layer as the source electrodes SE and the drain electrodes DE, and may extend from the display area DA of the substrate to the non-display area NDA.

The display routing lines RL may be disposed in the routing area RA. For example, the display routing lines RL may be a first routing line. The display routing lines RL may be electrically connected to the pixel part 110 disposed in the display area DA of the substrate 100. The display routing lines RL may be disposed between the data lines DL and the panel driving circuit part 300. The first end portion of each of the display routing lines RL may be electrically connected to an end portion of each of the plurality of data lines DL in one side area of the non-display area NDA.

The pads 131 may be disposed in the pad area PA. The pads 131 may be a pad electrode configured in the pad part 130. The pads 131 may include a same material as the source electrodes SE and the drain electrodes DE and may be formed using a same process.

The passivation layer 114 may extend from the display area DA and may be disposed in the non-display area NDA and the routing area RA. The passivation layer 114 may be configured over the data lines DL and the display routing lines RL. The passivation layer 114 may be configured to cover the data lines DL and the display routing lines RL. The passivation layer 114 may configured to protect the data lines DL and the display routing lines RL.

The overcoat layer 115 may be disposed in the display area DA and the non-display area NDA of the substrate 100. The overcoat layer 115 may be disposed in the display area DA and the non-display area NDA between the display area DA and the routing area RA. The overcoat layer 115 may be formed over the passivation layer 114 which is disposed in the display area DA and the non-display area NDA.

The overcoat layer 115 may include an extension portion 115E extending to the routing area RA between the display area DA and the pad area PA. The extension portion 115E of the overcoat layer 115 may extend from the routing area RA along a direction from the end of the encapsulation part 150 toward the pad area PA. The extension portion 115E may extend past the end of the encapsulation part 150 into the routing area RA. For example, the extension portion 115E of the overcoat layer 115 extends from the end of the encapsulation part 150 along a direction toward the pad area PA, past the end of the encapsulation part 150 and into the routing area RA.

At least a portion of the extension portion 115E of the overcoat layer 115 may have a same thickness T2 as a central portion of the overcoat layer 115. For example, a thickness T1 (or a longest distance) between an upper surface of the central portion of the overcoat layer 115 and the substrate 100 may be a same as the thickness T2 (or a longest distance) between an upper surface of the extension portion 115E and the substrate 100.

The routing area RA on the substrate 100 may include a first routing area RA1 and a second routing area RA2. The first routing area RA1 may be an area adjacent to the display area DA. The first routing area RA1 may be an area adjacent to the non-display area NDA. The second routing area RA2 may be an area extending from the first routing area RA1. The second routing area RA2 may be an area between the first routing area RA1 and the pad area PA.

As illustrated in FIG. 1, the substrate 100 may include a first side S1 and a second side S2 parallel to each other. The first side S1 and the second side S2 may be disposed parallel to each other along the first direction X. Each of the first side S1 and the second side S2 may be a first short-side and a second short-side of the non-display area NDA.

The extension portion 115E of the overcoat layer 115 may have a uniform thickness in the first routing area RA1. For example, the extension portion 115E of the overcoat layer 115 may have a same thickness T1 as a whole (or overall) in the first routing area RA1.

The extension portion 115E of the overcoat layer 115 may have a uniform thickness between the first side S1 and the second side S2 of the substrate 100. For example, the extension portion 115E of the overcoat layer 115 may have the same thickness as a whole (or overall) in region between the first side S1 and the second side S2. For example, the extension portion 115E may have a line shape corresponding to an entire area of the first routing area RA1 between the first side S1 and the second side S2 of the substrate 100 and may have the same thickness as a whole (or overall). The extension portion 115E may have a thickness decreasing from the boundary portion BP2 between the first routing area RA1 and the second routing area RA2 toward the pad area PA. For example, the extension portion 115E may have a progressively thinner thickness from the boundary portion BP2 toward the pad area PA.

The extension portion 115E of the overcoat layer 115 may include a first extension portion 115E1 disposed in the first routing area RA1 and a second extension portion 115E2 disposed in the second routing area RA2.

The first extension portion 115E1 may have the thickness T2 as a whole (or overall) in the first routing area RA1.

The second extension portion 115E2 may have a thickness decreasing from the boundary portion BP2 between the first routing area RA1 and the second routing area RA2 toward the pad area PA. The second extension portion 115E2 may include a curved portion extending from the boundary portion BP2 between the first routing area RA1 and the second routing area RA2 to an upper surface 113f of the second insulating layer (or interlayer insulating layer) 113. For example, the second extension portion 115E2 may be configured to have a thickness decreasing from the first extension portion 115E1 toward the upper surface 113f of the second insulating layer (or interlayer insulating layer) 113.

The pad protection layer 195 may cover one side end of the pad 131. The pad protection layer 195 may cover the one side end of the pad 131 adjacent to the routing area RA. The pad protection layer 195 may include a same material as the overcoat layer 115 and may be formed using a same process. The pad protection layer 195 may have a same or smaller thickness as the overcoat layer 115 and the extension portion 115E. The pad protection layer 195 may be configured to protect one side end of the pad 131 adjacent to the routing area RA.

The encapsulation part 150 may be disposed on the overcoat layer 115. The encapsulation part 150 may be disposed in the display area DA and the non-display area NDA. An end of the encapsulation part 150 may be located or aligned at the boundary portion BP1 between the display area DA and the routing area RA. The encapsulation part 150 may not be disposed in the routing area RA. The end of the encapsulation part 150 may be non-overlapped with the routing area RA. The extension portion 115E of the overcoat layer 115 may extend from the end of the encapsulation part 150 along a direction Y toward the pad area PA, past the end of the encapsulation part 150 into the routing area RA. For example, the extension portion 115E of the overcoat layer 115 may extend from the end of the encapsulation part 150 along the short-side length direction Y of the substrate 100, past the end of the encapsulation portion 150 into the routing area RA.

The encapsulation part 150 may include a first encapsulation part 151 and a third encapsulation part 153. In one side of the display area DA adjacent to the non-display area NDA, the first encapsulation part 151 may be disposed on the overcoat layer 115. In the one side of the display area DA adjacent to the non-display area NDA, the third encapsulation part 153 may be disposed on the first encapsulation part 151. The first encapsulation part 151 and the third encapsulation part 153 may include a same material. For example, the first encapsulation part 151 and the third encapsulation part 153 may include an inorganic insulating material.

According to an embodiment of the present disclosure, the first encapsulation part 151 and the third encapsulation part 153 may be formed using a chemical vapor deposition (CVD) method. For example, the first encapsulation part 151 and the third encapsulation part 153 of the substrate 100 may be formed by positioning a mask, which exposes one end of the display area DA and the non-display area NDA, on the upper surface of the extension portion 115E of the overcoat layer 115 disposed in the first routing area RA1, and depositing an inorganic insulating material.

According to an embodiment of the present disclosure, the extension portion 115E of the overcoat layer 115 disposed in the first routing area RA1 may have a uniform thickness in the first routing area RA1 and between the first side S1 and the second side S2 of the substrate 100. Accordingly, in the process of positioning a mask to form the first encapsulation part 151 and the third encapsulation part 153, a weight (or load) of the mask may be uniformly applied to an entire upper surface of the extension portion 115E of the overcoat layer 115. Thus, in the light emitting display apparatus 10, defects such as cracks, pressing, or dents (or indentations) caused by foreign particles or the like may be prevented.

For example, when the extension portion 115E of the overcoat layer 115 does not have a uniform thickness, the foreign particles may exist in thick portions, and when the mask is positioned on the thick portion of the extension portion 115E of the overcoat layer 115, a weight (or load) of the mask may be concentrated on the foreign particle portion, thereby causing defects such as dents (or indentations) caused by the foreign particles on the upper surface of the extension portion 115E of the overcoat layer 115.

According to an embodiment of the present disclosure, the light emitting display apparatus 10 may uniformly (or equally) maintain the thickness of the extension portion 115E of the overcoat layer 115 extended to the first routing area RA1, thereby expanding the contact area where the extension portion 115E of the overcoat layer 115 contacts the mask and uniformly maintaining the weight (or load) of the mask. Accordingly, during forming process of the encapsulation part of the light emitting display apparatus 10, defects such as cracks, pressing, or dents (or indentations) by the foreign particles or the like on the upper surface of the extension portion 115E of the overcoat layer 115 due to the weight (or load) of the mask may be prevented.

According to an embodiment of the present disclosure, in the light emitting display apparatus 10, since defects such as cracks, pressing, or dents (or indentations) by the foreign particles or the like on the upper surface of the extension portion 115E of the overcoat layer 115 due to the weight (or load) of the mask may be prevented, weakening (or deficiency) of the step coverage of an upper layer formed after the encapsulation part 150 may be prevented. Accordingly, in the light emitting display apparatus 10, since a moisture permeation path from the outside may be blocked, hydrogen and moisture may be prevented from penetrating into the display panel, and deterioration of the light emitting display apparatus may be prevented. Thus, reliability of the light emitting display apparatus may be improved, a long lifespan may be realized, and low-power driving may be possible.

According to an embodiment of the present disclosure, the light emitting display apparatus 10 may support a mask for forming an encapsulation part 150 without an additional process and may prevent defects such as cracks, pressing, and/or dents (or indentations) and the like occurring in a contact region between the mask and the extension portion 115E, by including an extension portion 115E in which the overcoat layer 115 extends to a routing area RA and configuring such that at least a portion of the extension portion 115E has a same thickness as a central portion of the overcoat layer 115.

The light emitting display apparatus 10 according to an embodiment of the present disclosure may further include a plurality of touch electrodes TE.

The plurality of touch electrodes TE may be the second touch electrode layer 167 described above with reference to FIG. 3. The plurality of touch electrodes TE may be disposed in the display area DA of the substrate 100 and on the one side of the non-display area NDA of the substrate 100 adjacent to the routing area RA.

The light emitting display apparatus 10 according to an embodiment of the present disclosure may further include a plurality of touch routing lines TRL. The plurality of touch routing lines TRL may be disposed in the routing area RA and the pad area PA of the substrate 100. The plurality of touch routing lines TRL may be disposed between the touch electrodes TE and the pad part 130. The plurality of touch routing lines TRL may electrically connect the plurality of touch electrodes TE to the pad part 130. A first end portion of each of the plurality of touch routing lines TRL may be connected to each of the plurality of touch electrodes TE. A second end portion may be connected to an upper surface of each of the plurality of pad 131 configured in the pad part 130.

Each of the plurality of touch routing lines TRL may pass over the upper surface of the extension portion 115E of the overcoat layer 115. For example, each of the plurality of touch routing lines TRL may pass (or pass through) over the upper surface of the extension portion 115E of the overcoat layer 115 and be electrically connected to a corresponding touch data pad among the plurality of touch data pad 131. For example, the extension portion 115E of the overcoat layer 115 may support the plurality of touch routing lines TRL. A portion of each of the plurality of touch routing lines TRL may be in direct contact with the upper surface of the extension portion 115E of the overcoat layer 115. Each of the plurality of touch routing lines TRL may be in direct contact with the second insulating layer 113 in a part of the routing area RA. For example, each of the plurality of touch routing lines TRL may be in direct contact with the second insulating layer 113 in the second routing area RA2.

Each of the plurality of touch routing lines TRL may be spaced apart from the plurality of display routing lines RL with the extension portion 115E of the overcoat layer 115 therebetween. The extension portion 115E of the overcoat layer 115 may protect the display routing line RL on the display routing line RL, and may electrically insulate the plurality of touch routing lines TRL and the display routing line RL.

The light emitting display apparatus 10 according to an embodiment of the present disclosure may further include a touch protection layer 169 and a cover layer 180.

The touch protection layer 169 may be disposed over the display area DA and at least a portion of the non-display area NDA adjacent to the routing area RA. The touch protection layer 169 may cover the plurality of touch electrodes TE. The touch protection layer 169 may cover the second touch electrode layer 167.

The cover layer 180 may cover the routing area RA and the pad area PA. The cover layer 180 may be disposed over the plurality of touch routing lines TRL. The cover layer 180 may protect the plurality of touch routing lines TRL. For example, the cover layer 180 may include a same material as the touch protection layer 169 and may be formed using a same process.

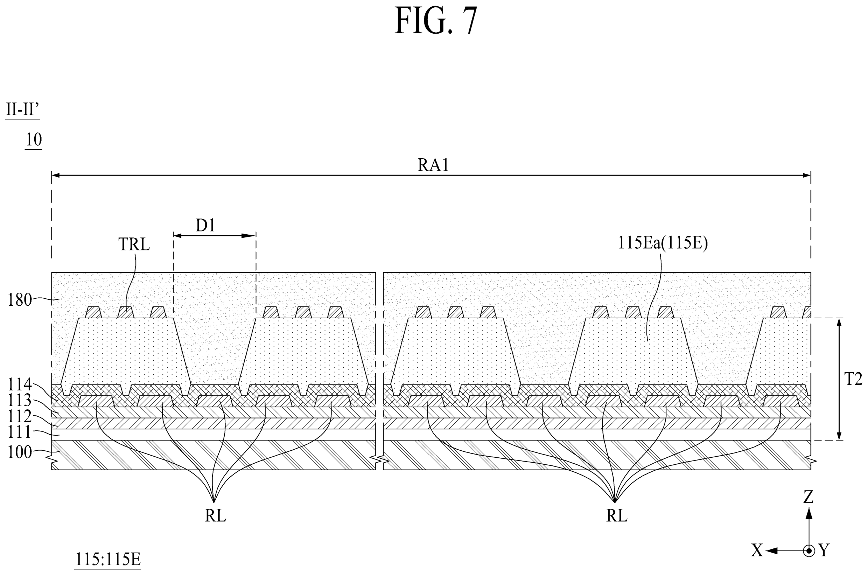

FIG. 7 is a cross-sectional view taken along line II-II' of FIG. 4 according to another embodiment. FIG. 7 illustrates an embodiment where the extension portion of the overcoat layer according to an embodiment of the present disclosure described above with reference to FIG. 6 is modified. In the following description, therefore, redundant descriptions of the other elements other than the extension portion of the overcoat layer and relevant elements will be omitted or briefly described.

Referring to FIGs. 1, 3 to 5, and 7, in the light emitting display apparatus 10 according to another embodiment of the present disclosure, the extension portion 115E of the overcoat layer 115 may include a plurality of protrusions 115Ea which is disposed in the first routing area RA1 of the routing area RA.

The plurality of protrusions 115Ea may be disposed in parallel along the first direction X of the substrate 100. Each of the plurality of protrusions 115Ea may be disposed to have a predetermined first interval D1 along the first direction X of the substrate 100. Each of the plurality of protrusions 115Ea may be disposed to have the predetermined first interval D1 along a direction from the first side S1 toward the second side S2 of the substrate 100.

Each of the plurality of protrusions 115Ea may have a same thickness T2 as the central portion of the overcoat layer 115 disposed in the display area DA. Each of the plurality of protrusions 115Ea may have a thickness T2 that is the same as each other. For example, the thickness T2 from the substrate 100 to an upper surface of each of the plurality of protrusions 115Ea may be a same. For example, a distance (or a longest distance) between the upper surface of each of the plurality of protrusions 115Ea and the substrate 100 may be a same.

The light emitting display apparatus 10 according to an embodiment of the present disclosure may further include a plurality of touch routing lines TRL.

Each of the plurality of touch routing lines TRL may pass over the upper surface of the extension portion 115E of the overcoat layer 115. Each of the plurality of touch routing lines TRL may pass over the upper surface of the protrusion 115Ea. For example, the protrusion 115Ea may support the plurality of touch routing lines TRL. A portion of each of the plurality of touch routing lines TRL may be in direct contact with the protrusion 115Ea. Each of the plurality of touch routing lines TRL may pass (or pass through) over the upper surface of the protrusion 115Ea of configured at the extension portion 115E of the overcoat layer 115 and be electrically connected to a corresponding touch data pad among the plurality of touch data pads. Each of the plurality of touch routing lines TRL may be in direct contact with the second insulating layer 113 at a portion of the routing area RA. For example, each of the plurality of touch routing lines TRL may be in direct contact with the second insulating layer 113 at the second routing area RA2.

Each of the plurality of touch routing lines TRL may be spaced apart from the plurality of display routing lines RL with the plurality of protrusions 115Ea therebetween. The plurality of protrusions 115Ea may protect the display routing line RL on the display routing line RL, and may electrically insulate the plurality of touch routing lines TRL and the display routing line RL.

According to another embodiment of the present disclosure, the light emitting display apparatus 10 may include the plurality of protrusions 115Ea configured (or formed) with a same thickness (or an entirely same thickness) on the extension portion 115E of the overcoat layer 115, and thus, the weight (or load) of the mask may be uniformly distributed or dispersed on an entire upper surfaces of each of the plurality of protrusions 115Ea in the process of positioning the mask to form the first encapsulation part 151 and the third encapsulation part 153. Accordingly, in the light emitting display apparatus 10, defects such as cracks, pressing, or dents (or indentations) caused by the foreign particles or the like may be prevented.

According to another embodiment of the present disclosure, the light emitting display apparatus 10 may include the plurality of protrusions 115Ea having the same thickness, weakening (or deficiency) of the step coverage of an upper layer formed after the encapsulation part 150 may be prevented. Accordingly, in the light emitting display apparatus 10, since a moisture permeation path from the outside may be blocked, hydrogen and moisture may be prevented from penetrating into the display panel, and deterioration of the light emitting display apparatus may be prevented. Thus, reliability of the light emitting display apparatus may be improved, a long lifespan may be realized, and low-power driving may be possible.

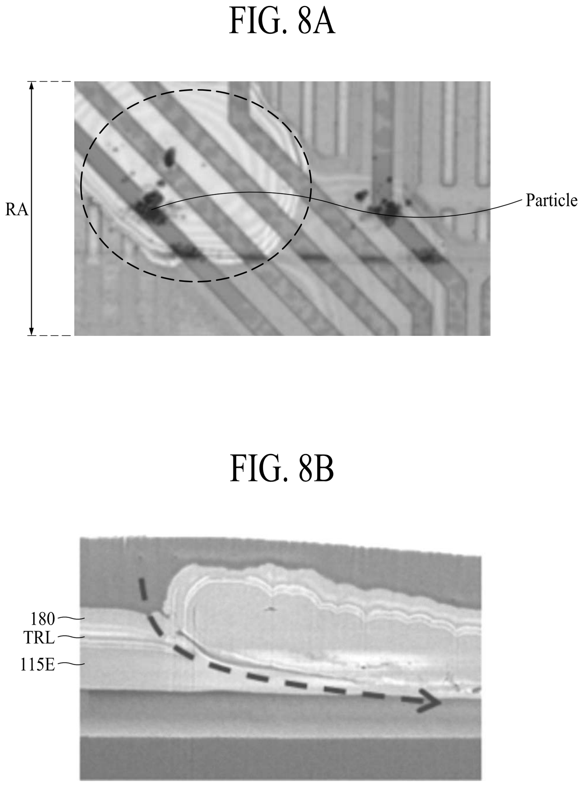

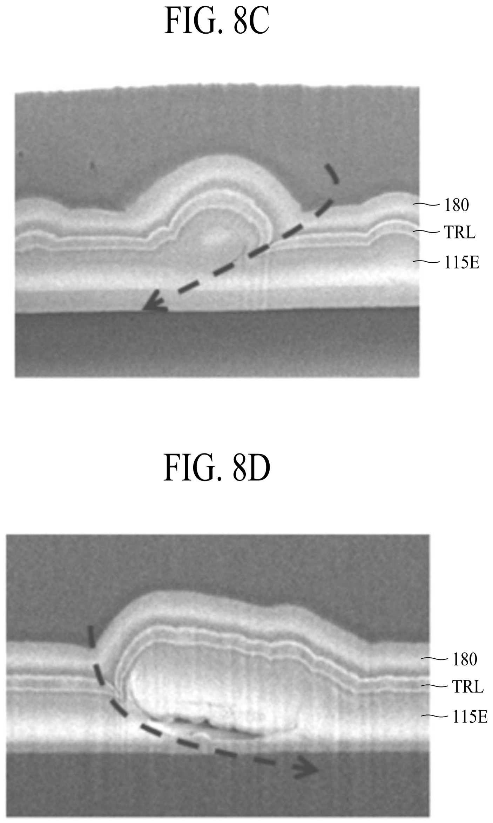

FIGs. 8A to 8D are diagrams illustrating defects in a routing area of a light emitting display apparatus according to an experimental example. FIGs. 8A to 8D are diagrams illustrating defects occurring in the routing area of a light emitting display apparatus in which a thickness of the extension portion of the overcoat layer is not uniform. FIG. 8A is a diagram illustrating a plane of the routing area, and FIGs. 8B to 8D are diagrams illustrating a cross-section of a region where defects have occurred. In FIG. 8A, a circled portion indicated by a dotted line is the portion where a dent defect (or an indentation defect) has occurred, and a portion indicated in black is the portion where a foreign particle exists. In FIGs. 8B to 8D, a portion indicated by a dotted arrow is a portion that serves as a permeation path.

Referring to FIGs. 8A to 8D, it could be confirmed that a dent defect caused by a mask occurred in the routing area of the light-emitting display apparatus in which the thickness of the extension portion of the overcoat layer was not uniformly configured. For example, in the case where the thickness of the extension portion is not uniform, a weight (or load) of the mask positioned on the upper side of a thick portion of the extension portion may be concentrated on the thick portion of the extension portion compared to a thin portion of the extension portion. At this time, the foreign particles existing on the mask may be concentrated in large numbers in the region where the thickness of the extension portion is thick, so that a foreign particle defect may occur, or the dent defect (or the indentation defect) of the mask may occur in the thick portion of the extension portion where a weight (or load) of the mask is concentrated. Furthermore, when an upper layer (or upper film) is formed on a portion where the dent defect (or the indentation defect) occurred, it could be confirmed that the step coverage of the upper layer became weak (or deficient). For example, it could be confirmed that a crack was generated in the upper layer (or upper film) of the portion where the dent defect (or the indentation defect) occurred. Such the weak (or deficient) portion or the crack may become a path of moisture penetration and may cause deterioration and reliability problems of the light emitting display apparatus.

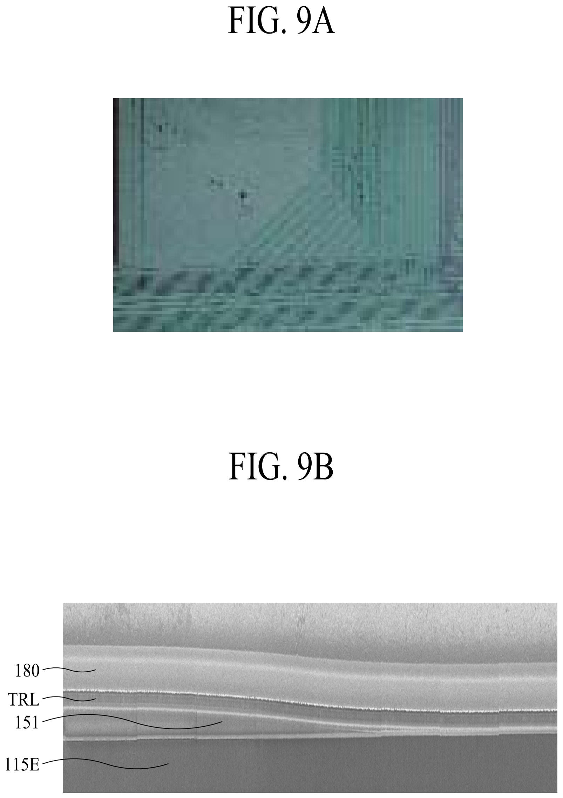

FIGs. 9A and 9B are diagrams illustrating a routing area of a light emitting display apparatus according to an embodiment of the present disclosure. FIGs. 9A and 9B are diagrams a routing area of the light emitting display apparatus in which a thickness of the extension portion of the overcoat layer is uniformly configured as described above with reference to FIGs. 1 to 6. FIG. 9A is diagram illustrating a plane of the routing area, and FIG. 9B is diagram illustrating a cross-section of the routing area.

Referring to FIGs. 9A and 9B, in the routing area of the light emitting display apparatus in which the thickness of the extension portion of the overcoat layer is uniformly configured according to an embodiment of the present disclosure, it could be confirmed that the dent defect (or the indentation defect) caused by the mask does not occur. Accordingly, it could be confirmed that the upper layer (or upper film) was formed uniformly. Therefore, in the light-emitting display apparatus according to an embodiment of the present disclosure, it could be confirmed that a path for moisture penetration may be blocked, and the deterioration and reliability problems of the light emitting display apparatus may be improved.

A light emitting display apparatus according to an embodiment of the present disclosure may be applied to or included in mobile apparatuses, video phones, smart watches, watch phones, wearable apparatuses, foldable apparatuses, rollable apparatuses, bendable apparatuses, flexible apparatuses, curved apparatuses, sliding apparatuses, variable apparatuses, electronic organizers, electronic books, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, automotive apparatuses, theatre apparatuses, theatre display apparatuses, TVs, wall paper display apparatuses, signage apparatuses, game machines, notebook computers, monitors, cameras, camcorders, and home appliances, or the like.

It will be apparent to those skilled in the art that various modifications and variations can be made in the present disclosure without departing from the scope of the disclosures. Thus, it is intended that the present disclosure covers the modifications and variations of this disclosure provided that within the scope of the claims and their equivalents.

## Claims

1. A light emitting display apparatus, comprising:
a substrate comprising a display area and a pad area;
a pixel circuit layer including a pixel circuit configured in the display area;
an overcoat layer configured in the display area to cover the pixel circuit layer;
a light emitting device layer configured on the overcoat layer and electrically connected to the pixel circuit;
an encapsulation part configured on the overcoat layer to cover the light emitting device layer; and
a pad part configured in the pad area and electrically connected to the pixel circuit,
wherein the overcoat layer includes an extension portion extending to a routing area between the display area and the pad area, and
wherein at least a portion of the extension portion of the overcoat layer has a same thickness as a central portion of the overcoat layer.

2. The light emitting display apparatus of claim 1, wherein an end of the encapsulation part is located at a boundary portion between the display area and the routing area.

3. The light emitting display apparatus of claim 2, wherein the extension portion of the overcoat layer extends from the end of the encapsulation part along a direction toward the pad area, past the end of the encapsulation part and into the routing area.

4. The light emitting display apparatus of any of claims 1 to 3, wherein:
the routing area comprises:
a first routing area adjacent to the display area, and
a second routing area between the first routing area and the pad area,
the extension portion of the overcoat layer has a same thickness as a whole in the first routing area.

5. The light emitting display apparatus of claim 4, wherein the extension portion of the overcoat layer has a thickness decreasing from a boundary portion between the first routing area and the second routing area toward the pad area.

6. The light emitting display apparatus of claim 4, wherein:
the substrate includes a first side and a second side parallel to each other, and
the extension portion of the overcoat layer has a same thickness as a whole between the first side and the second side.

7. The light emitting display apparatus of any one of claims 1 to 6, further comprising:
a touch sensing part including a plurality of touch electrodes disposed on the encapsulation part; and
a plurality of touch routing lines connected between the plurality of touch electrodes and the pad part,
wherein the extension portion of the overcoat layer is configured to support the plurality of touch routing lines.

8. The light emitting display apparatus of claim 7, wherein:
the pixel circuit layer comprises:
a gate line disposed on the substrate and connected to the pixel circuit;
an insulating layer covering the gate line;
a data line disposed on the insulating layer and connected to the pixel circuit; and
a passivation layer covering the data line and covered by the overcoat layer,
each of the plurality of touch routing lines is in direct contact with the insulating layer in at least a portion of the routing area.

9. The light emitting display apparatus of any one of claims 1 to 3, wherein:
the routing area comprises:
a first routing area adjacent to the display area, and
a second routing area between the first routing area and the pad area,
the extension portion of the overcoat layer includes a plurality of protrusions configured in the first routing area, and
each of the plurality of protrusions has a same thickness as a central portion of the overcoat layer.

10. The light emitting display apparatus of claim 9, wherein the extension portion of the overcoat layer has a thickness decreasing from a boundary portion between the first routing area and the second routing area toward the pad area.

11. The light emitting display apparatus of claim 9 or 10, wherein:
the substrate includes a first side and a second side parallel to each other, and
the plurality of protrusions are disposed to have a predetermined interval along a direction from the first side toward the second side.

12. The light emitting display apparatus of any of claims 9 to 11, wherein a distance between an upper surface of each of the plurality of protrusions and the substrate is a same.

13. The light emitting display apparatus of any of claims 9 to 12, further comprising:
a touch sensing part including a plurality of touch electrodes disposed on the encapsulation part; and
a plurality of touch routing lines connected between the plurality of touch electrodes and the pad part,
wherein the plurality of protrusions are configured to support the plurality of touch routing lines.

14. The light emitting display apparatus of claim 13, wherein:
the pixel circuit layer comprises:
a gate line disposed on the substrate and connected to the pixel circuit;
an insulating layer covering the gate line;
a data line disposed on the insulating layer and connected to the pixel circuit; and
a passivation layer covering the data line and covered by the overcoat layer,
each of the plurality of touch routing lines is in direct contact with the insulating layer in at least a portion of the routing area.
